Europäisches Patentamt

European Patent Office

Office européen des brevets

(11) Veröffentlichungsnummer: **0 253 098**
.A1

## (12) EUROPÄISCHE PATENTANMELDUNG

(21) Anmeldenummer: **87107205.4**

(22) Anmeldetag: **18.05.87**

(51) Int. Cl.⁴ **G01R 31/28**

Die Bezeichnung der Erfindung wurde geändert (Richtlinien für die Prüfung im EPA, A-III, 7.3).

(30) Priorität: **21.05.86 DE 3617044**

(43) Veröffentlichungstag der Anmeldung:
**20.01.88 Patentblatt 88/03**

(84) Benannte Vertragsstaaten:
**AT DE FR GB IT NL**

(71) Anmelder: **Siemens Aktiengesellschaft Berlin.
und München
Wittelsbacherplatz 2
D-8000 München 2(DE)**

(72) Erfinder: **Brust, Hans-Detlef
Martin-Luther Strasse 2
D-6602 Dudweiler(DE)**

(54) **Messverarbeitungsanordnung für durch Korpuskularstrahlung erzeugte Signalfolgen.**

(57) Meßverarbeitungsanordnung zur Meßverarbeitung von Signalverläufen hochfrequenter periodischer Meßsignale über n parallel geschaltete Meßverarbeitungseinheiten (MV1, MV2...MVn) mit n vorgeschalteten Torschaltungen (TORE1, TORE2...TOREn), die n zeitlich versetzte Meßsignale periodisch verarbeiten und n Mittelungen über je m Abtastungen bilden.

## FIG 4

EP 0 253 098 A1

## Meßverarbeitungsanordnung für Korpuskularstrahlung.

Die Erfindung betrifft eine Meßverarbeitungsanordnung für Korpuskularstrahlung zur Messung von Signalverläufen hochfrequenter periodischer Meßsignale nach dem Oberbegriff des Anspruchs 1.

Zur Messung von Signalverläufen hochfrequenter periodischer Meßsignale mit einem Elektronenstrahl verwendet man häufig ein Sampling-oder ein kombiniertes Sampling-und Averaging-Verfahren. Das Sampling-Verfahren gewährleistet eine hohe Zeitauflösung, da es aus einer Reihe von Perioden zeitlich versetzte Abschnitte entnimmt und diese zu einer langsameren neuen Probe derselben Gestalt zusammensetzt. Ein Averaging-Verfahren sorgt für ein gutes Signalrauschverhältnis, da der Meßwert über eine Reihe von Perioden mehrfach abgetastet und gemittelt wird. Diese Verfahren werden sowohl in der Oszillographentechnik als auch in der Elektronenstrahlmeßtechnik eingesetzt. Bei der Elektronenstrahlmeßtechnik können elektrische Potentiale an der Oberfläche integrierter Schaltungen abgebildet und gemessen werden. Die meisten integrierten Schaltungen müssen dabei dynamisch geprüft werden, dies bedeutet, sie müssen während der Untersuchung mit Nennfrequenz arbeiten.

Ausgangspunkt der Entwicklung in der Elektronenstrahlmeßtechnik ist der "Potentialkontrast" (Phys. B. 38 (1982), Nr. 8, Elektronenstrahl-Meßtechnik zur Prüfung integrierter Schaltungen von Hans Rehme). In einem Raster-Elektronenmikroskop wird hierfür mit Hilfe von Ablenkspulen ein fokussierter Primärelektronenstrahl über die abzubildende Probenoberfläche geführt. Ein Detektor erfaßt die dabei ausgelösten Sekundärelektronen und eine nachgeschaltete Meßverarbeitungsanordnung nützt diese Meßsignale zur Helligkeitsmodulation eines Bildschirms. Es ist bekannt, daß in der Elektronenstrahlmeßtechnik zur Realisierung von kombinierten Sampling-und Averaging-Verfahren sogenannte Boxcar-Integratoren verwendet werden (US Patent 4 486 660 Electron Beam Testing Device For Stroboscopic Measurement of High-Frequency, Periodic Events). Der Boxcar-Integrator besteht dabei im wesentlichen aus einer Phasensteuerungseinheit, einer Verzögerungseinheit, einer Torschaltung und einer Meßverarbeitungseinheit. Die Blockaufbaustruktur eines Boxcar-Integrators sowie eine Verschaltung in einem Elektronenstrahlmeßgerät ist in Figur 10 auf Seite 20 der Zeitschrift Scanning Volume 5 14/24 (1983) im Artikel Electron Beam Testing: Methods and Applications von H. P. Feuerbaum angegeben. Ein Boxcar-Integrator, der nach dem kombinierten Sampling-und Averaging-Verfahren arbeitet, ist beispielsweise das Modell 162 der Firma Princeton Applied Research, siehe Model 162 Boxcar Averager EG&G, Princeton Applied Research Operating and Service Manual. Eine weitere Offenlegungsschrift DE 31 992 A1 gibt ein Abtastverfahren zur schnellen Potentialbestimmung in der Elektronenstrahlmeßtechnik an. In dieser Offenlegungsschrift wird die schnelle Potentialbestimmung dadurch erreicht, daß während einer Periode des periodischen Signalverlaufs dieser mehrmals von einem gepulsten Elektronenstrahl abgetastet wird.

In der zuletzt genannten Offenlegungsschrift werden jedoch keine Angaben gemacht wie das Abtastverfahren praktisch durchgeführt werden kann und es ist im übrigen ausschließlich auf die Elektronenstrahlmeßtechnik beschränkt. Unvorteilhaft bei den bisher verwendeten Boxcar-Integratoren ist die hohe Meßzeit, die sich aus dem Sampling-Verfahren und der maximalen Meßrate des Boxcars ergeben. Beim Sampling Verfahren werden n Abtastpunkte in n Perioden des Meßsignals gemessen, wobei sich der Abstand zwischen Nulldurchgang des Meßsignals und Abtastpunkt mit wachsender Anzahl der Abtastpunkte verändert. Beim Sampling-und Averaging-Verfahren wird das Zeitintervall mit der das Signal gemessen werden soll in n meist äquidistante Abtastpunkte zerlegt und für jeden Abtastpunkt das Meßsignal m mal abgetastet. Dieser Vorgang wird für den nächsten Abtastpunkt wiederholt, so daß die Meßzeit

$$n \cdot m \, \frac{1}{\text{max. Meßrate}} \quad (\text{falls } \frac{1}{\text{max. Meßrate}} \geq T);$$

T = Periodendauer des Meßsignals) beträgt. Dies kann bei Messungen sehr schneller Signale, bei der man mit sehr kurzen Elektronenimpulsen arbeitet und dadurch sehr viele Messungen durchführen muß, zu Meßzeiten von etlichen Minuten führen. Derartig lange Meßzeiten führen aber wegen Instabilitäten der Meßanordnung und Drifterscheinungen zu außerordentlichen hohen Meßfehlern.

Der Erfindung liegt die Aufgabe zugrunde, die Meßzeiten in einem Sampling oder Sampling-und Averaging-Verfahren erheblich zu reduzieren. Außerdem soll die Meßverarbeitungsanordnung universell einsetzbar sein, beispielsweise in der Elektronenstrahlmeßtechnik oder in der Oszillographentechnik.

Die Erfindung wird durch eine Meßverarbeitungsanordnung gelöst, die die kennzeichnenden Merkmale des Anspruchs 1 aufweist.

Benötigt man in der Elektronenstrahlmeßtechnik neben einem mehr qualitativen Potentialkontrastsignal auch eine Angabe über die tatsächliche Spannungshöhe so ist eine Regelung insbesondere eine Abtastregelung vorzusehen, wobei je ein Ausgang einer Meßverarbeitungseinheit (MV1, MV2...MVn) mit je einer Regelungseinheit (R1, R2...Rn) mit nachgeschalteter aus einem Eingang, Ausgang und Steuereingang bestehenden Torschaltung (TORA1, TORA2... TORAn) verbunden ist, alle Ausgänge der Torschaltungen (TORA1, TORA2, TORAn) gemeinsam mit einem Spektrometer insbesondere einem Gegenfeldspektrometer (GF), verbunden sind, der Steuereingang der Torschaltung (TORA1) mit dem Steuereingang der Torschaltung (TORE1) verbunden ist und die Steuereingänge der Torschaltungen (TORA2...TORAn) entsprechend mit den Steuereingängen der Torschaltung (TORE2...TOREn) verbunden sind.

Um die Meßverarbeitungsanordnung den Meßzeiten anzupassen, haben in einer weiteren Ausbildung der Erfindung die Meßverarbeitungseinheiten (MV1, MV2...Mn) je eine Integratorstufe, die eine Mittelung ausführen, oder insbesondere bei sehr kurzen Meßzeiten haben die Meßverarbeitungseinheiten (MV1, MV2...MVn) je eine Zählerstufe, die eine Zählung kurzer zu messender Meßsignale ausführen.

Andere Ausbildungen der Erfindung sind Gegenstand der Unteransprüche.

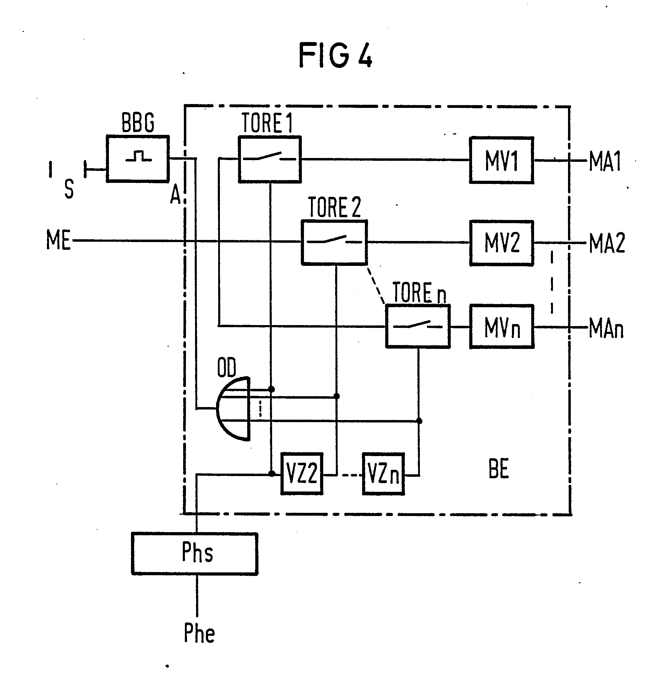

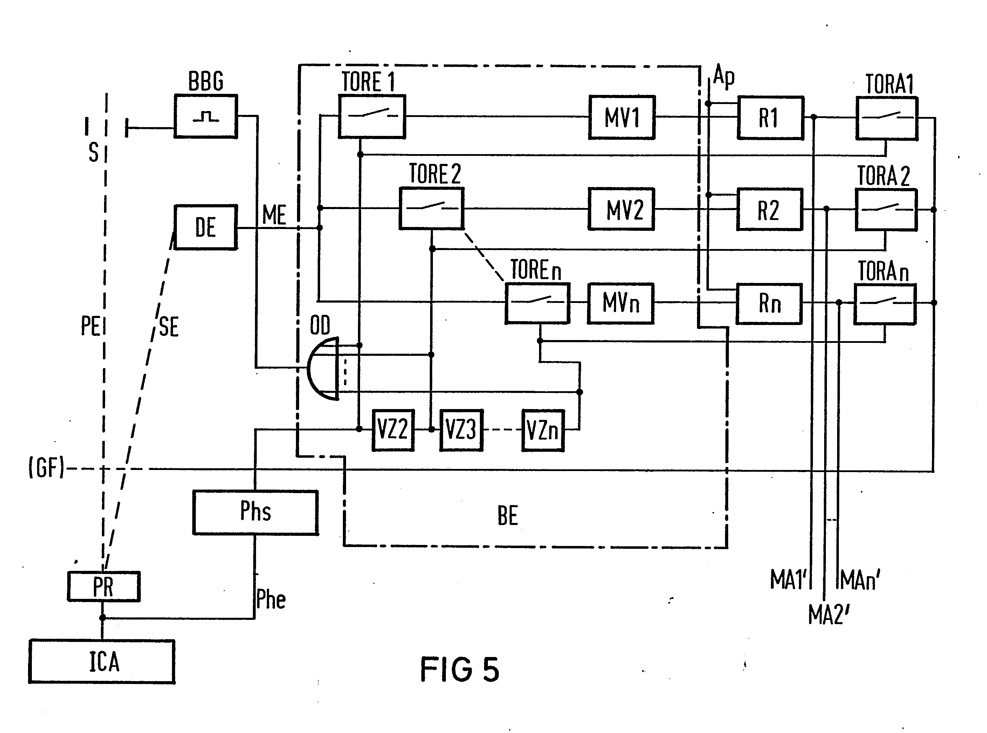

Die Erfindung wird anhand von zwei Ausführungsbeispielen (Figur 4 und Figur 5) weiter erläutert. Es zeigen:

Figur 1 eine zu messende periodische Spannung U (t),

Figur 2 eine Eintastung des Primärelektronenstrahls bei dem herkömmlichen Meßverfahren,

Figur 3 eine Eintastung des Primärelektronenstrahls nach der durch die Erfindung durchgeführten Messung,

Figur 4 eine Meßverarbeitungsanordnung für Korpuskularstrahlung mit angeschlossenem Beamblanking-Generator und Strahlaustastsystem,

Figur 5 ein Elektronenstrahlmeßgerät mit einer rückgekoppelten Meßverarbeitungsanordnung für Korpuskularstrahlung.

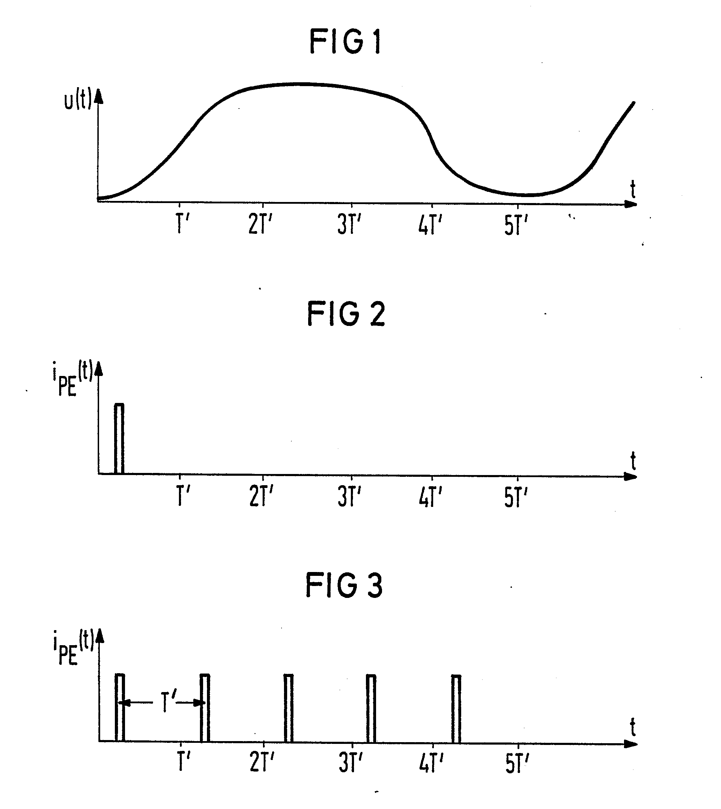

In Figur 1 ist die zu messende periodische Spannung U (t) dargestellt. Die Periodendauer beträgt T = 5T'. Bei der herkömmlichen Messung Figur 2 führt ein Triggerereignis erst nach einer Zeit

$$t' = \frac{1}{\text{Meßrate}}$$

(meist 1 μsec) nach der letzten Messung zu einer neuen Messung. Hierzu wird der Primärelektronenstrahl ipe (t) höchstens einmal in der Periode T eingetastet und der Sekundärelektronenstrom anschließend gemessen.

In einer nach der Erfindung Figur 3 durchgeführten Messung löst ein Triggerereignis nicht nur eine sondern mehrere in diesem Fall fünf Messungen aus. Hierzu wird der Primärelektronenstrahl ipe (t) mehrmals, hier fünfmal, eingetastet und der Sekundärelektronenstrom wird entsprechend oft gemessen.

Zu diesem Zweck werden in der Meßverarbeitungsanordnung der Erfindung hintereinandergeschaltete Verzögerungsglieder eingesetzt, die zum einen die mehrfache Eintastung des Primärelektronenstrahls in einer Periode steuern und zum andern die Aufgabe haben, über Torschaltungen die Meßsignale zeitlich versetzt auf die parallelgeschalteten Meßverarbeitungseinheiten anzulegen. In den Meßverarbeitungseinheiten werden die n Meßsignale periodisch verarbeitet und n Mittelungen über je m Abtastungen gebildet. Bei gutem Signal/Rauschverhältnis kann dabei m = 1 sein, wobei in diesem Fall die n Meßwerte nicht über n Mittelungen gebildet werden.

Die in Figur 4 dargestellte Meßverarbeitungsanordnung für Korpuskularstrahlung besteht aus einer Boxcar-Einheit BE mit einem Meßeingang ME, einem Eingang zur Phasensteuerung PHE, einem Ausgang A zum Anschluß an einen Beam-blanking-Generator BBG mit nachgeschaltetem Strahl austastsystem S und Meßausgängen MA1, MA2...MAn. Der Eingang der Phasensteuerung PHE ist mit einer Phasensteuerung PHS verbunden. Aus einem Triggersignal am Ausgang der Phasensteuerung PHS werden zum Beispiel mit Hilfe von hintereinander geschalteten Verzögerungsgliedern weitere jeweils um T zeitverschobene Triggersignale abgeleitet, die dann über den Beam-blanking-Generator BBG das Strahlaustastsystems S ansteuern und die Primärelektronen erzeugen. Der Ausgang der Phasensteuerung PHS ist zusätzlich mit einem Eingang eines aus n Eingängen bestehenden ODER Gatters OD sowie gegebenenfalls über eine weitere Verzögerungseinheit zum Ausgleich der Elektronenlaufzeit mit dem Steuereingang der Torschaltung TORE1 verbunden. Die Ausgänge der Verzögerungsglieder VZ2... VZn sind entsprechend mit den Eingängen des ODER Gatters OD und den Steuereingängen der Torschaltung TORE2...TOREn verbunden. Über den Ausgang des ODER Gatters OD wird der Beam-blanking-Generator BBG direkt angesteuert. Das Meßsignal wird über den Eingang ME und die n parallel geschalteten Torschaltungen TORE1, TORE2 ....TOREn in Abhängigkeit von den Signalen auf den Steuereingängen der Torschaltungen an eine der Meßverarbeitungseinheiten MV1, MV2... oder MVn angelegt. Diese Meßverarbeitungseinheiten können aus einer Integratorstufe oder aus einer Zählerstufe bestehen. Die Ausgänge der Meßverarbeitungseinheiten bilden die Ausgänge MA der Boxcareinheit, hier können die Meßsignale abgegriffen werden.

Figur 5 zeigt ein Elektronenstrahlmeßgerät mit einer rückgekoppelten Meßverarbeitungsanordnung für Korpuskularstrahlung. Die Boxcar-Einheit in Figur 5 entspricht der Boxcar-Einheit aus Figur 4. Die Grundeinheit des Elektronenstrahlmeßgeräts bildet dabei ein Rasterelektronenmikroskop mit einer Strahlaustastung S. Der Primärelektronenstrahl PE löst auf der Probe PR Sekundärelektronen SE aus, die in der Detektoreinheit DE erfaßt werden. Die Detektoreinheit besteht zum Beispiel aus einer Szintillatorphotomultiplierkombination oder bei der Verwendung eines schnelleren Detektionssystems aus einer Channel-plate oder einem Halbleiterdetektor. Die Probe PR zumeist eine integrierte Schaltung ist an eine IC-Ansteuerung ICA angeschlossen und wird von dieser mit Testsignalen versorgt. Das Elektronenstrahlmeßgerät mit einer rückgekoppelten Meßverarbeitungsanordnung besteht weiter aus einem Gegenfeldspektrometer GF, n parallel geschalteten Reglern R1, R2....Rn mit je einer nachgeschalteten Torschaltung TORA1, TORA2...TORAn. Der Sollwert des Arbeitspunktes AP wird gemeinsam jedem Regler über einen seiner zwei Eingänge zugeführt. Über den anderen Eingang wird der Istwert des Meßwertes in den Regler eingespeist. Dazu ist der Ausgang der Meßverarbeitungseinheit MV1 mit dem Istwerteingang des Reglers R1 verbunden, dies gilt entsprechend für die übrigen Meßverarbeitungseinheiten MV2...MVn und die Regler R2...Rn. Die Ausgänge der Torschaltung TORA1, TORA2... TORAn sind direkt an das Gegenfeldspektrometer GF angeschlossen. Da den n Meßwerten n Abtastwerte zugeordnet sind, werden die Torschaltungen TORE1 und TORA1 synchron betrieben, hierzu sind die Steuereingänge der beiden Torschaltungen gemeinsam miteinander verbunden. Dies gilt entsprechend für die Torschaltungen TORE2...TOREn und den Torschaltungen TORA2... TORAn. Die rückgekoppelte Meßverarbeitungsanordnung arbeitet so, daß die Spannung am Gegenfeldspektrometer in Abhängigkeit vom Meßpunktpotential so nachgeregelt wird, daß der Strom der Sekundärelektronen SE konstant bleibt. Die Boxcareinheit weist wie in Figur 1 zwei Eingänge auf, einen Meßeingang ME, der mit der Detektoreinheit verbunden ist, sowie einen Phasensteuerungseingang PHE, der mit der IC-Ansteuerungsschaltung ICA verbunden ist. An den Ausgängen MA'1, MA'2...MA'n der Boxcar-Einheit ist es möglich, die verarbeiteten Meßsignale abzugreifen, sie dienen dazu, beispielsweise einen Rechner anschließen zu können.

Obwohl sich die zuvor beschriebenen Ausführungsbeispiele auf ein Elektronenmikroskop beziehen, ist die Erfindung so zu verstehen, daß anstelle von Elektronen auch Ionen, Photonen oder andere Korpuskeln verwendet werden können, und zwar sowohl als Primärkorpuskeln als auch als Sekundärkorpuskeln.

Die Meßverarbeitungsanordnung ist überall dort einsetzbar, wo die Meßzeiten bei einem Sampling-oder Sampling-und Averaging-Verfahren zu verringern sind, ihr Einsatz ist deshalb nicht nur auf die Elektronenstrahlmeßtechnik oder Oszillographenmeßtechnik beschränkt.


Bezugszeichenliste U(t)      zu messende periodische Spannung
i PE(t)    Stromstärke des primären Elektronenstrahls
T'     Zeitfaktor
BBG      Beam blanking Generator
S     Strahlaustastsystem
A      Ausgang zum Anschluß des Beam blanking Generator
TORE1, TORE2...TOREn      Torschaltungen
TORA1, TORA2...TORAn
OD   . ODER Gatter
MV1, MV2...MVn      Meßverarbeitungseinheit
VZ2, VZ3...VZn      Verzögerungseinheit
ME     Meßeingang
MA1, MA2...MAn      Meßausgänge
MA1', MA2'...MAn'
BE     Boxcareinheit
Phs     Phasensteuerung
Phe     Eingang zur Phasensteuerung
GF     Gegenfeldspektrometer
PR     Probe

ICA    IC-Ansteuerung
AP    Arbeitspunkt
R1, R2...Rn    Regler

## Ansprüche

1. Meßverarbeitungsanordnung zur Meßverarbeitung von Signalverläufen hochfrequenter periodischer Meßsignale mit einer Boxcareinheit (BE) und einer Phasensteuerung (PHS), **dadurch gekennzeichnet,** daß die Boxcareinheit n parallel geschaltete Meßverarbeitungseinheiten (MV1, MV2...MVn) mit n vorgeschalteten Torschaltungen (TORE1, TORE2...TOREn) enthält, die n zeitlich versetzte Meßsignale verarbeiten.

2. Meßverarbeitungsanordnung nach Anspruch 1, **dadurch gekennzeichnet,** daß an die Boxcareinheit (BE) ein Strahlaustastsystem (S) mit vorgeschaltetem Beam blanking Generator (BBG) angeschlossen ist, das einen Korpuskularstrahl steuert.

3. Meßverarbeitungsanordnung nach Anspruch 2, **dadurch gekennzeichnet,** daß die Boxcareinheit (BE) aus einem ODER Gatter (OD) mit n-Eingängen und n-1 Verzögerungsgliedern (VZ2...VZn) besteht, daß ein Ausgang der Phasensteuerung mit den n-1 hintereinandergeschalteten Verzögerungsgliedern (VZ2...VZn), einen Eingang des ODER Gatters (OD) und mit einem Steuereingang der Torschaltung (TORE1) verbunden ist, daß die Ausgänge der Verzögerungsglieder (VZ2...VZn) entsprechend mit den Eingängen des ODER Gatters (OD) und Steuereingängen der Torschaltungen (TORE2...TOREn) verbunden sind, um so n Meßsignale zeitlich versetzt zu verarbeiten, daß der Ausgang des ODER Gatters (OD) mit dem Beam blanking Generator (BBG) verbunden ist, um den Elektronenstrahl auszutasten.

4. Meßverarbeitungsanordnung nach Anspruch 1 oder 3, **dadurch gekennzeichnet,** daß je ein Ausgang einer Meßverarbeitungseinheit (MV1, MV2...MVn) mit je einer Regelungseinheit (R1, R2...Rn) mit nachgeschalteter aus einem Eingang, Ausgang und Steuereingang bestehenden Torschaltung (TORA1, TORA2... TORAn) verbunden ist, daß alle Ausgänge der Torschaltungen (TORA1, TORA2...TORAn) gemeinsam mit einem Spektrometer insbesondere einem Gegenfeldspektrometer (GF) verbunden sind, daß der Steuereingang der Torschaltung (TORA1) mit dem Steuereingang der Torschaltung (TORE1) verbunden ist, daß die Steuereingänge der Torschaltungen (TORA2... TORAn) entsprechend mit den Steuereingängen der Torschaltung (TORE2...TOREn) verbunden sind.

5. Meßverarbeitungsanordnung nach Anspruch 4, **dadurch gekennzeichnet,** daß die Regelungseinheiten je aus einem Regler bestehen, der einen Soll-Ist-Wert-Vergleich zwischen einem Arbeitspunkt (AP) und dem verarbeiteten Meßwert durchführt.

6. Meßverarbeitungsanordnung nach einem der Ansprüche 1 bis 5, **dadurch gekennzeichnet,** daß die Meßverarbeitungseinheiten (MV1, MV2...MVn) je eine Integratorstufe enthalten, die eine Mittelung ausführen.

7. Meßverarbeitungsanordnung nach einem der Ansprüche 1 bis 5, **dadurch gekennzeichnet,** daß die Meßverarbeitungseinheiten (MV1, MV2...MVn) je eine Zählerstufe enthalten, die eine Zählung kurzer zu messender Meßsignale ausführen.

## FIG 1

## FIG 2

## FIG 3

# FIG 4

FIG 5

0 253 098

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | EP-A-0 048 858 (SIEMENS) * Seite 3, Zeile 34 - Seite 5, Zeile 25; Abbildung * | 1 | G 01 R 31/28 |
| | --- | | |
| A,D | EP-A-0 075 710 (SIEMENS) | | |
| | --- | | |
| A | DE-A-3 235 700 (SIEMENS) | | |
| | ----- | | |

RECHERCHIERTE
SACHGEBIETE (Int. Cl.4)

G 01 R

Der vorliegende Recherchenbericht wurde für alle Patentansprüche erstellt.

| Recherchenort | Abschlußdatum der Recherche | Prüfer |
|---|---|---|
| DEN HAAG | 07-08-1987 | KUSCHBERT D.E. |